# EUROPEAN PATENT APPLICATION

(11) **EP 2 224 484 A1**
(43) Date of publication of application: **01.09.2010**
(21) Application number: 08865477.7
(22) Date of filing: 28.11.2008
(51) Int. Cl.: H01L 25/07, H01L 25/18

(54) **SEMICONDUCTOR MODULE**

(30) Priority: 25.12.2007 JP 2007331353
(71) Applicant: Toyota Jidosha Kabushiki Kaisha, Toyota-shi, Aichi 471-8571 (JP)
(72) Inventor: OGAWA, Naoki, Toyota-shi Aichi 471-8571 (JP)
(74) Representative: Smith, Samuel Leonard
(86) International application number: PCT/JP2008/071605
(87) International publication number: WO 2009/081689

(57) **Abstract**

Provided is a semiconductor module (100) wherein a stress relaxing layer (45) is arranged between a ceramic substrate (20) whereupon a semiconductor elements (10) (IGBT (11), diode (12)) are mounted and a cooling device on the rear side of the ceramic substrate (20), and the ceramic substrate, the cooling device and the stress relaxing layer are integrally formed. Furthermore, the stress relaxing layer (45) is separated into a plurality of separated sections (45A, 45B, 45C, 45D) by two slits (461, 462). Furthermore, the slits (461, 462) are positioned between the semiconductor elements when viewed from the thickness direction of the stress relaxing layer (45) and not in a projection region of the semiconductor element.

## Description

### Technical Field

The present invention relates to a semiconductor module in which an insulating substrate on which a semiconductor element is mounted and a cooling member are placed on opposite sides of a stress relaxing layer.

### Background Art

A high-pressure-resistant and large-current power module to be mounted in a hybrid electric vehicle, an electric vehicle, etc. provides a large self-heating value or amount during operation of a semiconductor element. Such in-vehicle power module therefore has to include a cooling structure having high heat dissipation performance.

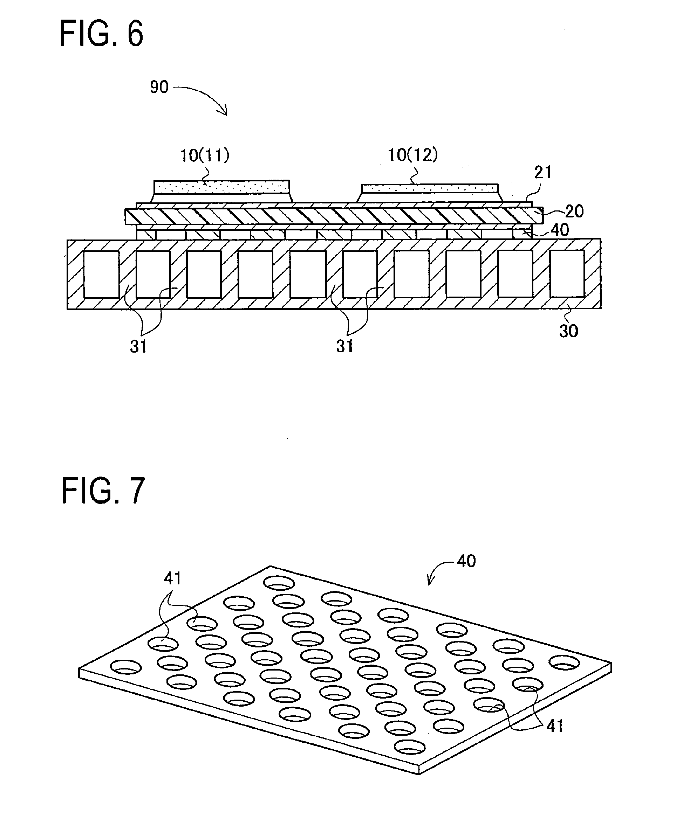

FIG. 6 shows an example of a power module having a cooling structure. A power module 90 includes a plurality of semiconductor elements 10, a ceramic substrate 20 on which the elements 10 are mounted, and a cooler 30 internally formed with coolant flow paths. In the power module 90, the cooler 30 dissipates or disperses the heat generated from the semiconductor elements 10.

The power module 90 configured as above is apt to cause stress concentration due to differences in coefficient of linear expansion. Specifically, the linear expansion coefficient of the ceramic substrate 20 is as small as 4 to 6 ppm/°C, whereas the linear expansion coefficient of the cooler 30 is as relatively large as 23 ppm/°C.

To absorb this difference in linear expansion coefficient, therefore, a stress relaxing layer 40 is placed between the ceramic substrate 20 and the cooler 30 (see Patent Literature 1). The stress relaxing layer 40 is made of a material having high heat conductivity and a linear expansion coefficient close to that of the cooler 30, i.e., high-purity aluminum or the like. This stress relaxing layer 40 is formed with a number of through holes 41 as shown in FIG. 7 whereby to absorb linear expansion strain between the ceramic substrate 20 and the cooler 30.

### Citation List

### Patent Literature

Patent Literature 1: JP-A-2006-294699

### Summary of Invention

### Technical Problem

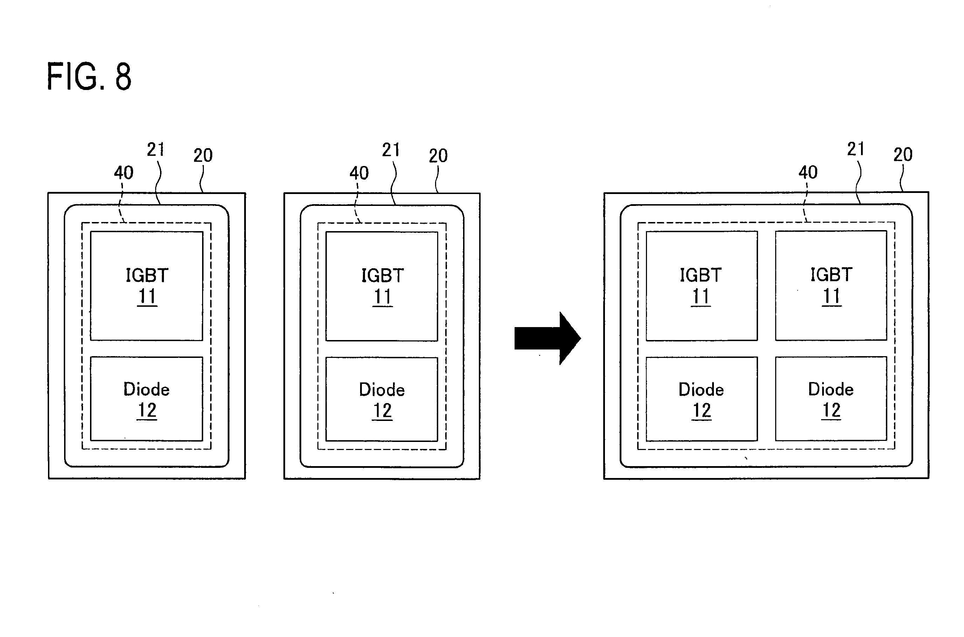

Recently, there is proposed a configuration that more elements 10 (e.g., IGBTs 11 and diodes 12) than before are arranged on a single large-size ceramic substrate 20 as shown in FIG. 8. This could reduce spaces or intervals between the semiconductor elements 10, resulting in size reduction of the entire power module.

However, the case of using the large-size ceramic substrate 20 would involve the following problems. Specifically, this case could prompt size reduction of the entire power module but the ceramic substrate 20 itself increases in size. Such size increase of the ceramic substrate 20 leads to size increase of the stress relaxing layer 40. Thus, larger strain is liable to occur in the stress relaxing layer 40 (mainly, in its outer peripheral portion) and a stress relaxing effect of the layer 40 becomes insufficient. This causes warps, cracks, and others in the ceramic substrate 20. In particular, cracks in the ceramic substrate 20 beneath or near the semiconductor element(s) 10 would cause a large damage.

The stress relaxing layer in Patent Literature 1 is continuous excepting each through hole 41 as shown in FIG. 7. The stress strain in the stress relaxing layer and the ceramic substrate will be increased as their outer size is larger. In the case of utilizing the ceramic substrate 20 having a wide plane for mounting a semiconductor element, the stress relaxing effect is insufficient.

It is further conceivable that the stress relaxing effect can be enhanced by forming more through holes 41 or increasing the diameter of each through hole 41. However, the through hole 41 is a space, which is low in heat conductivity. If the stress relaxing layer 40 is formed with many spaces, a heat transfer path is interrupted by those spaces. Accordingly, it is preferable to form the smallest number of the through holes 41 in order to ensure high heat dissipation. In other words, the stress relaxing layer 40 also functions to transfer heat to the cooler 30, and hence enhancing of the stress relaxing effect and ensuring of high heat conductivity are in trade-off relation.

The present invention has been made to solve the above problems in the conventional semiconductor device and has a purpose to provide a semiconductor module capable of enhancing a stress relaxing effect and also ensuring high heat conductivity.

### Solution to Problem

To achieve the above purpose, one aspect of the invention provides a semiconductor module comprising: a cooling member (a heat sink); a ceramic substrate on which a plurality of semiconductor elements are placed; and a stress relaxing layer having a surface joined with the ceramic substrate and another surface joined with the cooling member, the stress relaxing layer having both a heat transfer function and a stress relaxing function, the stress relaxing layer including at least one slit whereby the stress relaxing layer is divided into a plurality of separated parts, and the slit or slits being placed within a non-semiconductor element region on the surface of the stress relaxing layer, the non-semiconductor element region being other than a projection region of the semiconductor element as seen in a thickness direction of the stress relaxing layer.

In the semiconductor module of the invention, the stress relaxing layer is placed between the ceramic substrate on which the semiconductor elements are mounted and the cooling member and they are joined together. The stress relaxing layer is divided into the plurality of separated parts by at least one slit. Even if the cooling member and the ceramic substrate expand or contract in different amounts from each other due to temperature variations during reliability evaluation of temperature cycle performance and others and during use in market, the stress strain to be exerted on each separated part is small. It is therefore possible to reliably absorb the stress strain, prevent cracks or warp of the ceramic substrate and a joining material, thereby ensuring high reliability.

Furthermore, if an in-plane area of the stress relaxing layer is sectioned into a projection region of the semiconductor elements and a non-semiconductor element region other than the projection region as seen in the thickness direction of the stress relaxing layer, the slit(s) is located within the non-semiconductor element region. Specifically, the slit(s) which is a space is not provided within the semiconductor element region. Accordingly, little influence is exerted on the heat transfer path. High heat conductivity can therefore be ensured.

In case the ceramic substrate is cracked or broken, such cracking or breaking is likely to occur in the non-semiconductor element region apart from the semiconductor elements. This can avoid crucial damages at an initial stage of cracking.

Furthermore, at least one of the slits is located between the semiconductor elements. Thus, the semiconductor elements are separately arranged in the separated parts. The stress strain is shared by the separated parts and each separated part can exert a stress relaxing effect within respective stress relaxing abilities.

Moreover, at least one of the slits extends across the stress relaxing layer. Specifically, the presence of the slit(s) extending across the stress relaxing layer can achieve size reduction in outer periphery of each separated part. Thus, each separated part can more reliably exert its stress relaxing abilities.

The separated parts of the stress relaxing layer has different sizes according to placement of the semiconductor elements. Specifically, the position of each slit is designed according to the semiconductor elements. Thus, each separated part can more reliably exert its stress relaxing ability and also enable high design freedom of placement of the semiconductor elements.

### Advantageous Effects of Invention

According to the invention, a semiconductor module can enhance a stress relaxing effect and also ensure high heat conductivity.

### Brief Description of Drawings

FIG. 1 is a schematic sectional view of a power module in an embodiment;
FIG. 2 is a perspective view of a stress relaxing layer in the embodiment;
FIG. 3 is a plan view showing a positional relationship between a semiconductor element and a slit in the embodiment;
FIG. 4 is a schematic view showing a region of the stress relaxing layer in the embodiment;
FIG. 5 is a plan view showing a positional relation between a semiconductor element and a slit in a modified example;
FIG. 6 is a schematic sectional view of a power module in a prior art;
FIG. 7 is a perspective view of a stress relaxing layer in the prior art; and
FIG. 8 is a plan view showing a positional relationship between a semiconductor element and a slit in the prior art.

### Description of Embodiments

A detailed description of a preferred embodiment of the present invention will now be given referring to the accompanying drawings. In the following embodiments, the present invention is explained as an intelligent power module for hybrid electric vehicle.

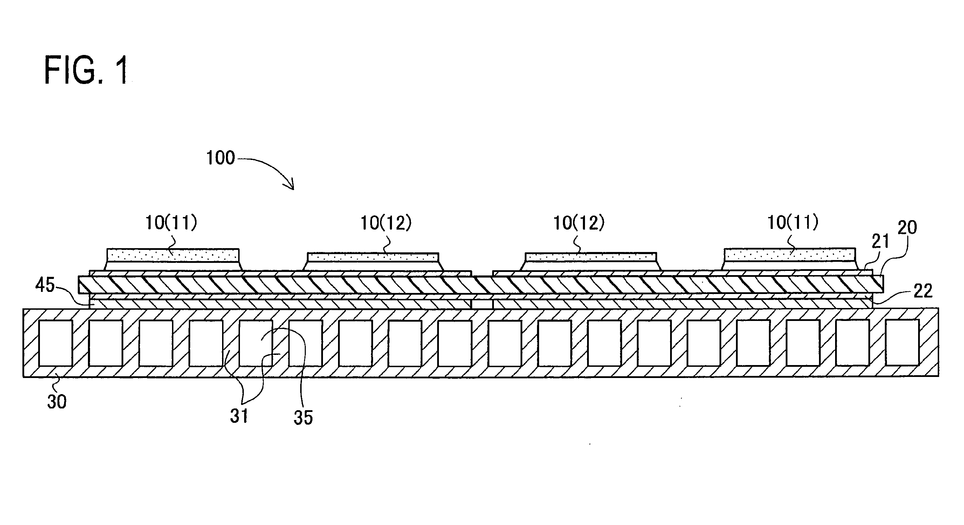

A power module 100 in this embodiment includes, as shown in FIG. 1, semiconductor elements 10 which generates heat, a ceramic substrate 20 for mounting thereon the semiconductor elements 10, a cooler 30 internally formed with coolant flow paths, and a stress relaxing layer 45 placed between the ceramic substrate 20 and the cooler 30 to provide a stress relaxing function for relaxing stress strain caused by a difference in coefficient of linear expansion between the ceramic substrate 20 and the cooler 30. In the power module 100, the heat generated from the semiconductor elements 10 is dissipated by the cooler 30 through the ceramic substrate 20 and the stress relaxing layer 45.

Each semiconductor element 10 is an electronic component (in this embodiment, IGBT is indicated by 11 and a diode is indicated by 12) constituting an inverter circuit. A plurality of the semiconductor elements 10 are mounted and fixed on the ceramic substrate 20 by soldering. It is to be noted that an in-vehicle power module mounts thereon many semiconductor elements but only part of them is schematically illustrated in this description to simplify explanation thereof.

The ceramic substrate 20 may be made of any ceramics, as long as it has necessary insulating characteristics, heat conductivity, and mechanical strength. For example, aluminum oxide or aluminum nitride is applicable. In this embodiment, the ceramic substrate 20 is made of aluminum nitride (AlN). The linear expansion coefficient thereof is 4.6 ppm/°C almost equal to that of the basic material, AIN.

Furthermore, metal pattern layers 21 are provided on an upper surface of the ceramic substrate 20. The pattern layers 21 are made of a material having high electric conductivity and high wettability with solder. For example, the pattern layer 21 may be made of high-purity aluminum coated with nickel plating. On the other hand, metal layers 22 are provided on a lower surface of the ceramic substrate 20. The metal layers 22 are made of a material having high heat conductivity and excellent wettability with brazing material. For example, high-purity aluminum is applicable.

The stress relaxing layer 45 is provided with stress absorbing space for absorbing stress strain caused by a difference in linear expansion coefficient between the aluminum cooler 30 and the ceramic substrate 20. The stress relaxing layer 45 in this embodiment is an aluminum plate having a high purity of 99.99% or more. The linear expansion coefficient of the high-purity aluminum stress relaxing layer 45 is 23.5 ppm/°C equal to a natural value of aluminum. High-purity aluminum is a relatively soft material having a Young's modulus of 70.3 GPa and hence tends to be largely deformed under stress. Accordingly, this can reduce stress strain between the cooler 30 and the ceramic substrate 20.

Furthermore, the high-purity aluminum forming the stress relaxing layer 45 has high heat conductivity. The stress relaxing layer 45 therefore has a function of dissipating the heat from the semiconductor elements 10 in a plane direction of the stress relaxing layer and also transfer the heat to the cooler 30. In other words, the stress relaxing layer 45 serves to relax stress and also transfer heat.

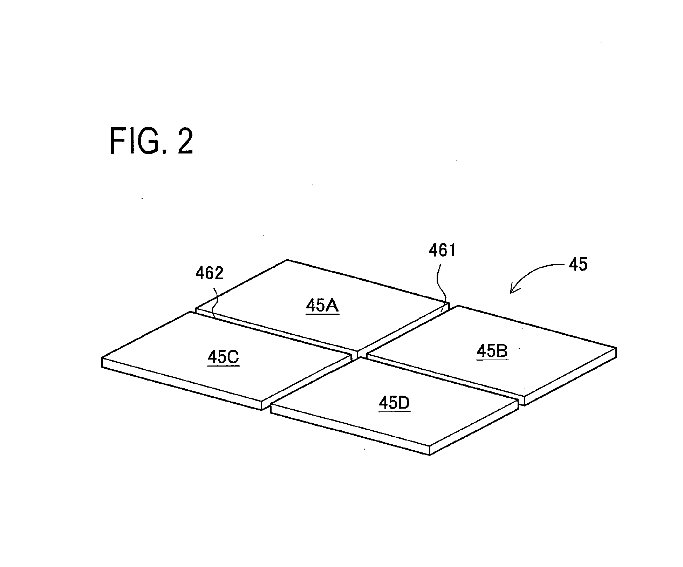

The stress relaxing layer 45 is also provided with two slits 461 and 462 in a mating surface with the ceramic substrate 20 as shown in FIG. 2. In the stress relaxing layer 45, the slits 461 and 462 serve as stress absorbing spaces. These slits 461 and 462 are formed to pass through the stress relaxing layer 45 in its thickness direction (in a vertical direction in FIG. 1). In plan view, furthermore, one slit 461 laterally extends across the stress relaxing layer 45 and the other slit 462 vertically extends across the stress relaxing layer 45. That is, the stress relaxing layer 45 is completely divided into a plurality of separated sections (parts) by the slits 461 and 462. To be concrete, the stress relaxing layer 45 in this embodiment is divided in four, separated parts 45A, 45B, 45C, and 45D by the slits 461 and 462. A positional relationship between the slits 461 and 462 and the semiconductor elements 10 will be described later.

The cooler 30 internally has cooling fins 31 arranged in rows at equal intervals and coolant flow paths 35 each formed between adjacent fins 31. Each component constituting the cooler 30 is preferably made of aluminum having high heat conductivity and light weight. The coolant is selectable from liquid and gas.

The ceramic substrate 20 and the stress relaxing layer 45 are directly joined to the cooler 30 by brazing in order to efficiently transfer the heat from the semiconductor element 10 to the cooler 30. The brazing material is selectable from aluminum brazing materials such as Al-Si alloy and Al-Si-Mg alloy. In this embodiment, the Al-Si alloy is used for brazing at a temperature of near 600°C. The joining of the cooler 30 and the stress relaxing layer 45 and others may be performed at the same time of producing the cooler 30.

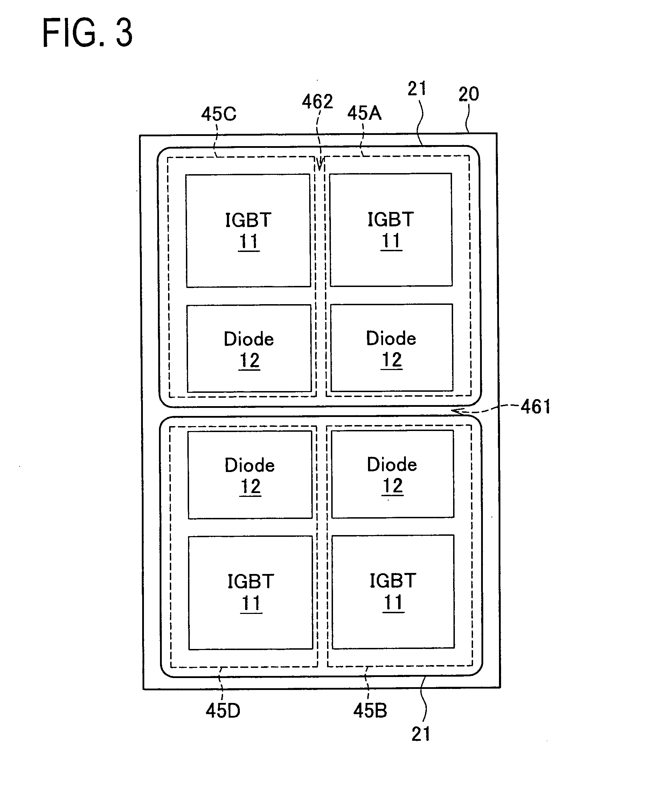

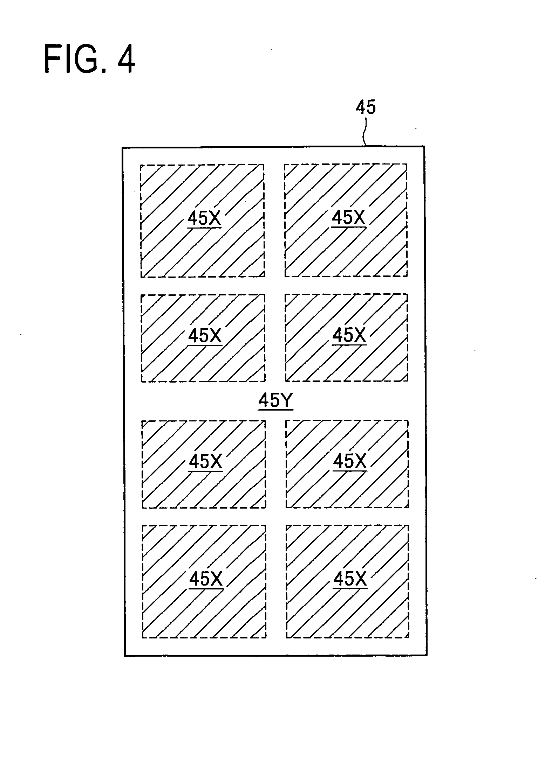

Next, the positional relationship between the semiconductor elements 10 on the ceramic substrate 20 and the slits 461 and 462 of the stress relaxing layer 45 in the power module 100 of this embodiment will be explained in detail referring to FIGs. 3 and 4.

FIG. 3 is a plan view showing one example of the placement of the semiconductor elements 10 (IGBTs 11 and diodes 12) on the ceramic substrate 20. In FIG. 3, respective positions of the separated parts 45A, 45B, 45C, and 45D of the stress relaxing layer 45 are indicated by broken lines. In this embodiment, as seen in the thickness direction of the stress relaxing layer 45, one IGBT 11 and one diode 12 are arranged on each of the separated parts 45A, 45B, 45C, and 45D. To be more specific, one IGBT 11 and one diode 12 are placed in one separated part without bridging a clearance (space) between the adjacent separated parts.

In other words, the slits 461 and 462 of the stress relaxing layer 45 are not located under the semiconductor elements 10. FIG. 4 shows the plane of the stress relaxing layer 45 divided into element regions 45X each being located under each semiconductor element 10 as a projection region of each semiconductor element 10 and a non-element region 45Y not located under the semiconductor elements 10 as seen in the thickness direction of the stress relaxing layer. The slits 461 and 462 are provided within the non-element region 45Y and do not bridge across the element regions 45X.

In the power module 100 of this embodiment, the stress relaxing layer 45 is sectioned by the slits 461 and 462. Accordingly, even when the entire size of the stress relaxing layer 45 is increased in association with the size increase of the ceramic substrate 20, each separated part 45A, 45B, 45C, and 45D is smaller than the entire size of the stress relaxing layer 45. Thus, stress strain generated in each separated part 45A, 45B, 45C, and 45D is small and thus the stress relaxing layer 45 can entirely exhibit a sufficient stress relaxing effect.

The slits 461 and 462 are arranged between the semiconductor elements so that the semiconductor elements 11 and 12 are arranged uniformly in the separated parts 45A, 45B, 45C, and 45D. Thus, combinations of the semiconductor elements 11 and 12 are separately arranged in the separated parts 45A, 45B, 45C, and 45D. Accordingly, the stress strain is shared by each separated part 45A, 45B, 45C, and 45D. Each separated part 45A, 45B, 45C, and 45D can exert a stress relaxing effect within respective stress relaxing abilities.

The stress on the stress relaxing layer 45 and the ceramic substrate 20 is maximum in the vicinity of an outer peripheral portion of each of the divided separated parts 45A, 45B, 45C, and 45D. Each portion of the ceramic substrate 20 joined with each separated part 45A, 45B, 45C, and 45D is backed with each separated part 45A, 45B, 45C, and 45D and hence provides high strength. Accordingly, if the ceramic substrate 20 is strained to cracking or breaking point, such cracking or breaking is likely to occur in a portion of the ceramic substrate 20 not joined with the separated parts 45A, 45B, 45C, and 45D. That is, an area of the ceramic substrate 20 facing the slits 461 and 462 is apt to be broken.

However, in this embodiment, the semiconductor elements 10 are mounted on the ceramic substrate 20 in only areas corresponding to the separated parts 45A, 45B, 45C, and 45D. In other words, the slits 461 and 462 exist only in the non-element region 45Y between the semiconductor elements. Even if the ceramic substrate 20 is cracked or broken, therefore, such cracking or breaking occurs in a portion between the semiconductor elements 10. This can avoid crucial problems.

The presence of the slits 461 and 462 may lower the heat transferring function of the stress relaxing layer 45. However, the slits 461 and 462 are not placed under the semiconductor elements 10 which are heating elements. Specifically, the stress relaxing layer 45 exists all over each of the element regions 45X the most required to have a heat transfer performance. Accordingly, the influence on heat radiation property is mere small.

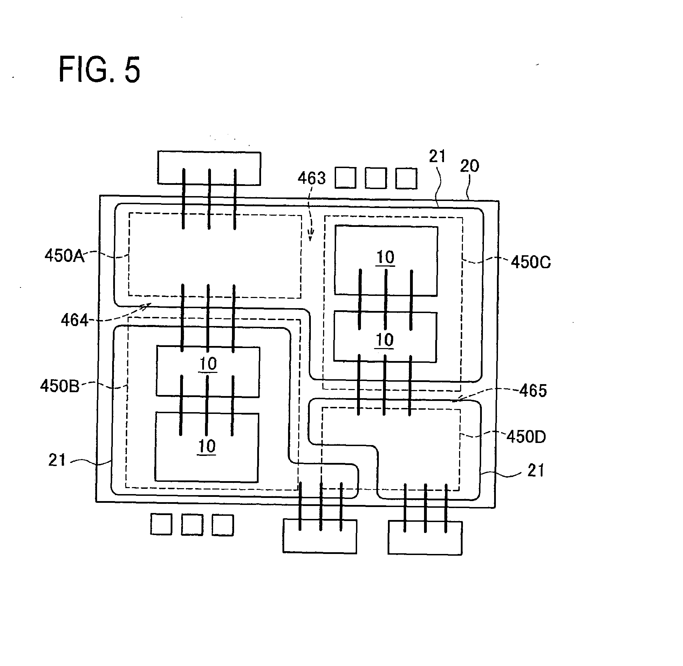

The stress relaxing layer 45 in this embodiment is divided into the separated parts 45A, 45B, 45C, 45D having almost the same size by the slits 461 and 462 but not limited thereto. For instance, as shown in FIG. 5, the size of each separated part may be adjusted by placement of the semiconductor elements 10. A semiconductor module shown in FIG. 5 is provided with three slits 463, 464, and 465 in a stress relaxing layer. Only the slit 463 extends across the stress relaxing layer and other slits 464 and 465 are placed to avoid the positions of the semiconductor elements 10. Those slits divide the stress relaxing layer into separated parts 450A, 450B, 450C, and 450D, each having different sizes. Thus, the design freedom of placement of the semiconductor elements 10 is not limited by the slits. The size of each separated part is adjustable within a range (e.g., 20 mm square x 1 mm thick) in which stress strain due to a difference in linear expansion coefficient between aluminum and ceramic does not exceed the strength of the ceramic substrate 20.

In this embodiment, two semiconductor elements 11 and 12 are placed in one separated part. As an alternative, a slit may further be provided between the semiconductor elements 11 and 12 so that one semiconductor element is placed in one separated part. If only one separated part can absorb stress strain, three or more semiconductor elements may be placed on the separated part.

According to the semiconductor module 100 of the present embodiment, as explained above in detail, the stress relaxing layer 45 includes four separated parts 45A, 45B, 45C, and 45D divided by the slits 461 and 462. In terms of the size, specifically, even when the entire size of the stress relaxing layer 45 is large, each of the separated parts 45A, 45B, 45C, and 45D is small. Even if the cooling member and the ceramic substrate expand or contract in different amounts from each other due to temperature variations during reliability evaluation of temperature cycle performance and others and during use in market, the stress strain to be exerted on each separated part is small. It is therefore possible to reliably absorb the stress strain, prevent cracks or warp of the ceramic substrate 20 and a joining material, thereby ensuring high reliability.

Furthermore, the slits 461 and 462 are located within the non-element region 45Y. In other words, the slits 461 and 462 are not located in the element regions 45X and thus exert little influence on a heat transfer path. High heat conductivity is thus ensured. Consequently, a semiconductor module can be provided capable of enhancing a stress relaxing effect and also ensuring high heat conductivity.

Even when the entire size of the stress relaxing layer 45 is large, the stress relaxing layer 45 can provide the stress relaxing effect and the high heat conductivity. This contributes to a size increase of the ceramic substrate 20 and a resultant compact power module.

The above embodiments are mere examples and apply no limitation to the present invention. Thus, the present invention may be embodied in other specific forms without departing from the essential characteristics thereof. For instance, the stress relaxing layer in the above embodiments is formed with the slits as the stress absorbing space but may be formed with a through hole(s) in addition to the slit(s). This configuration can provide a stress relaxing effect for each divided region.

Moreover, the member for radiating the heat from the semiconductor element(s) is not limited to the cooler having the coolant flow path. For instance, the member may be a heat radiating plate using a metal plate made of an inexpensive material (aluminum, copper, etc.) having high heat conductivity.

## Claims

1. A semiconductor module comprising:
a cooling member;
a ceramic substrate on which a plurality of semiconductor elements are placed; and
a stress relaxing layer having a surface joined with the ceramic substrate and another surface joined with the cooling member, the stress relaxing layer having both a heat transfer function and a stress relaxing function,
the stress relaxing layer including at least one slit whereby the stress relaxing layer is divided into a plurality of separated parts, and
the slit or slits being placed within a non-semiconductor element region on the surface of the stress relaxing layer, the non-semiconductor element region being other than a projection region of the semiconductor element as seen in a thickness direction of the stress relaxing layer.

2. The semiconductor module according to claim 1, wherein at least one of the slits is located between the semiconductor elements.

3. The semiconductor module according to claim 1 or 2, wherein at least one of the slits extends across the stress relaxing layer.

4. The semiconductor module according to one of claims 1 to 3, wherein the separated parts of the stress relaxing layer have different sizes according to placement of the semiconductor elements.
